# EUROPÄISCHE PATENTSCHRIFT

(11) **EP 0 574 451 B1**
(45) Veröffentlichungstag und Bekanntmachung des Hinweises auf die Patenterteilung: **17.11.1994**
(21) Anmeldenummer: 92905631.5
(22) Anmeldetag: 28.02.1992
(51) Int. Cl.: C25D 5/00

(54) **VORRICHTUNG ZUM ABBLENDEN VON FELDLINIEN IN EINER ANLAGE ZUR ELEKTROLYTISCHEN BEHANDLUNG VON IM WESENTLICHEN PLATTENFÖRMIGEM BEHANDLUNGSGUT (III)**
DEVICE FOR SCREENING OFF LINES OF ELECTRIC FLUX IN AN INSTALLATION FOR ELECTROLYTICALLY PROCESSING ESSENTIALLY FLAT ELEMENTS
DISPOSITIF D'ARRET DE LIGNES DE CHAMP AU MOYEN D'UN ECRAN POUR INSTALLATIONS DE TRAITEMENT ELECTROLYTIQUE D'ELEMENTS ESSENTIELLEMENT PLATS

(30) Priorität: 02.03.1991 DE 4106733
(43) Veröffentlichungstag der Anmeldung: 22.12.1993
(73) Patentinhaber: ATOTECH Deutschland GmbH, 10553 Berlin (DE)
(72) Erfinder: ASTOR, Kurt, D-8543 Hilpoltstein (DE); HAASE, Peter, D-8501 Feucht (DE); GUTE, Manfred, D-8500 Nürnberg 60 (DE)
(74) Vertreter: Effert, Udo, Dipl.-Ing.
(86) Internationale Anmeldenummer: DE9200182
(87) Internationale Veröffentlichungsnummer: WO9215727

(56) Entgegenhaltungen:
- US-A- 4 879 007

## Beschreibung

Die Erfindung geht aus von einer Vorrichtung zum Abblenden von Feldlinien in einer Anlage zur elektrolytischen Behandlung von im wesentlichen plattenförmigem, aus einem Werkstück oder aus mehreren Werkstücken bestehendem Behandlungsgut, das unterhalb eines Warenträgers gehalten ist und bei dessen Absenken in ein Bad eingebracht werden, wobei eine in Vertikalrichtung durch Niederhalter verstellbare Blende vorgesehen ist, die im Betrieb am unteren Bereich des Behandlungsgutes die o.g. feldlinienabblendung bewirkt, wobei die Niederhalter mit der Bewegung des Warenträgers gekoppelt sind (Oberbegriff des Anspruches 1). Dabei ist bevorzugt an das Galvanisieren von Leiterplatten gedacht. Die Erfindung könnte auch für die Behandlung anderer, ähnlicher Werkstücke und für den Einsatz in anderen Anlagen zur elektrolytischen Behandlung bestimmt sein, z.B. zur Durchführung einer Elektrophorese zum Aufbringen dünner, photoempfindlicher Schichten auf Leiterplatten.

Eine Vorrichtung zum Abblenden von Feldlinien in einer Galvanikanlage, die gemäß dem Oberbegriff des Anspruches 1 ausgebildet ist, ist in der nachveröffentlichten DE-OS 40 05 209 enthalten. Dazu wird u.a. eine Ausführung mit einem unteren Paar von Blenden beschrieben, die als Schwimmkörper ausgebildet sind und sich beiderseits des unteren Bereiches eines zu galvanisierenden plattenförmigen Behandlungsgutes befinden. Sie werden durch Niederhaltar in die gewünschte, untere Abblendposition gebracht. Diese Niederhalter sind an Gestellstäben befestigt, welche zwischen sich das zu galvanisierenden plattenförmige Behandlungsgut tragen und mit der Abwärtsbewegung des Warenträgers ebenfalls nach unten bewegt werden. Die vorgenannten, als Schwimmkörper ausgebildeten Blenden können aber nur um eine relativ geringe Strecke aus ihrer unteren Position nach oben bewegt werden, da sie an einer weiteren Bewegung nach oben durch einen Stopanschlag gehindert sind. Auch ist ein entsprechendes Anheben dieser unteren Blenden durch einen Seilzug möglich. Die vorstehend erläuterten unteren Blenden sind außerdem in Vertikalrichtung verstellbar am Badbehälter geführt. Dies gilt auch für dort ferner vorgesehene obere Blenden. Die DE-OS 40 05 209 erwähnt zwar, daß die dortige Erfindung sowohl im Fall des Anhängens der zu galvanisierenden Werkstücke mittels Klammern oder dergleichen an den Warenträgern oder auch bei solchen Anordnungen einsetzbar ist, bei denen die zu behandelnden Werkstücke sich zwischen sie haltenden Gestellstäben von Traggestellen befinden, die ihrerseits am Warenträger angebracht sind. Jedoch ist die vorstehend erläuterte Ausbildung zweier das untere Blendenpaar nach unten drückender Niederhalter dort nur in Form zweier Niederhalterteile an Gestellstäben eines Traggestelles offenbart. Beim Gegenstand von DE-OS 40 05 209 wird zwar die Kraft zur Bewegung der Blenden nach unten durch die Niederhalter aufgebracht, d.h. das zu behandelnde plattenförmige Gut wird mit dieser Kraft nicht belastet. Nachteilig sind aber die relativ aufwendige und viel Platz beanspruchende Ausgestaltung der beiden Blenden und insbesondere die Erfordernis, daß die Blenden an ihren Enden in Vertikalrichtung im Badbehälter geführt sind.

Eine Vorrichtung zum Abblenden von Feldlinien in einer Galvanikanlage ist ferner aus JP 55-145 199 A in Patents abstracts of Japan, Sect. C, Vol. 5 (1981) Nr. 16 (C-41) bekannt. Hierbei hat man bei einem Abschirmungs- und Positionierrahmen für solche Leiterplatten in Tauchgalvanikanlagen eine Blende vorgesehen, die wie ein Dachfirst ausgebildet ist und mit seitlichen Lappen in senkrecht verlaufenden Schlitzen einer Halterung geführt ist. Der "First" dieses "Daches" ist nach unten gerichtet. In ihrer Grundstellung befindet sich diese Blende auf der Badoberfläche oder im oberen Badbereich. Die zu behandelnde Leiterplatte wird mit ihrer unteren Kante von oben in das "Dachinnere" eingesetzt und nimmt die Blende beim Eintauchvorgang nach unten mit. Diese Blende verhindert sogenannte Anbrennungen, d.h. nicht erwünschte zusätzliche Ablagerungen der Metallisierung im unteren Randbereich der vorgenannten Leiterplatte. Diese vorbekannte Anordnung besitzt mehrere Nachteile. Das Niederdrücken der Blende muß über die zu behandelnde Leiterplatte erfolgen. Solche Platten sind aber oft sehr dünn, so daß sie die zum Niederdrücken erforderlichen Kräfte nicht unbeschadet übertragen können. In einem solchen Fall wölben sich die Leiterplatten unter der Einwirkung der Aufdrückkraft nach außen, was zu Beschädigungen dieser empfindlichen Platten und zu unterschiedlich dicken Niederschlägen auf deren konvexer und konkaver Seite führen kann. Eine der vorgenannten Abblendvorrichtung entsprechende Anordnung ist aus DE-PS 37 26 571 bekannt. Eine ähnliche Anordnung mit seitlichen Führungen der Blende am Badbehälter ist US-PS 4 879 007 zu entnehmen.

Die Aufgaben- bzw. Problemstellung der Erfindung geht von einer Vorrichtung gemäß dem Oberbegriff des Anspruches 1 aus. Unter Beibehaltung des durch die Niederhalter erzielten Vorteiles, daß das zu behandelnde Gut nicht mit der Niederdruckkraft für die Blenden beaufschlagt wird, soll eine Vorrichtung gemäß Oberbegriff des Anspruches 1 so ausgebildet werden, daß bei einfacher, platzsparender Bauweise die Nachteile einer Führung der Blende im Badbehälter vermieden sind.

Zur Lösung dieser Aufgaben- bzw. Problemstellung ist, ausgehend vom Oberbegriff des Anspruches 1, vorgesehen, daß die Niederhalter vom Warenträger nach unten ragende Stempel sind, die zur Auflage an beiden Endbereichen der Blende ausgebildet sind, wobei die unteren Enden der Stempel und die Endbereiche der Blende, auf welche diese Stempelenden zur Auflage kommen, so ausgebildet sind, daß sich die Blende zumindest in ihrer Längsrichtung nicht relativ zu den Stempeln verschieben kann, daß der Abstand zwischen den Stempeln größer ist als die Breite des bei der Behandlung zwischen den Stempeln befindlichen Behandlungsgutes, daß Mittel zum Transport der Blende aus der unteren Arbeitslage in eine obere Parkposition vorgesehen sind, daß das Behandlungsgut von dem Warenträger ohne seitliche Halterungen nach unten hängt und daß zwischen Badbehälter und Blende keine Führungen bestehen (Kennzeichen des Anspruches 1). Der Wegfall von Führungen der Blende am oder im Badbehälter bringt den Vorteil, daß dafür kein Platz benötigt wird. Der hierdurch in Richtung der Behälterbreite freiwerdende Platz dient zur Unterbringung der Stempel. Es kann also ohne zusätzlichen Raumbedarf durch die Stempel der Vorteil des Niederdrückens der Blende mit Hilfe dieser Stempel erreicht werden. Diese Kraft zum Bewegen der Blende aus der Parkposition in die Arbeitslage belastet das zu behandelnde Gut nicht. Dies ist insbesondere bei dem hauptsächlichen Anwendungsgebiet der Erfindung, nämlich dünnen Leiterplatten, von entscheidender Bedeutung, da diese Platten praktisch nicht in der Lage sind, nennenswerte, in ihrer Längsrichtung verlaufonde Kräfte aufzunehmen und zu übertragen. Das Absenken des Warenträgers bewegt also zugleich die beiden Stempel mit der Blende und das zwischen den Stempeln befindliche Behandlungsgut nach unten in die Arbeitslage. Ein weiterer Vorteil des Wegfalles von Führungen zwischen den Enden der Blende und dem Badbehälter liegt darin, daß solche Führungen nur schwer am Badbehälter anzubringen sind, insbesondere bei aus Stahl bestehenden Badbehältern, die in üblicher Weise mit einer Korrosionsschutzbeschichtung versehen sind. Eine solche Korrosionsschutzbeschichtung ist von unregelmäßiger Dicke und auch unregelmäßiger Oberfläche, weshalb sie sich selber nicht für eine Führung der Blenden eignet. Andererseits wäre es aber schwierig, an derart beschichteten Flächen des Badbehälters separate Führungsleisten, z.B. aus Kunststoff, zu befestigen. Gemäß der vorstehenden Lehre des Kennzeichens des Anspruches 1 wird die Aufgabe der bisher am Badbehälter vorgesehenen Führungen durch die Stempelenden übernommen. Diese Stempel und ihre Enden haben also eine Doppelfunktion, nämlich zum einen das Herunterdrücken der Blende in die Arbeitslage, und ferner deren Führung. Dies ist funktionell von Vorteil und dient darüber hinaus der baulichen Vereinfachung und der bereits erwähnten Platzersparnis innerhalb des Badbehälters. Das Behandlungsgut und die Stempel können miteinander nicht kollidieren, da die Stempel voneinander einen größeren Abstand als die Breite des Behandlungsgutes haben. Dies wird ergänzt durch die weitere Lehre des Anspruches 1, daß das Behandlungsgut, ohne seitlich gehalten zu sein, vom Warenträger direkt frei nach unten hängen kann, was darüber hinaus die Anbringung des Behandlungsgutes für das elektrolytische Behandeln sowie das nachherige Ablösen des Gutes erleichtert. Die vorstehend erläuterten Vorteile gelten auch gegenüber dem Stand der Technik nach JP 55-145 199A und DE-PS 37 26 571.

Ferner sind Mittel zum Transport und Rückbewegen der Blende aus der unteren Arbeitslage in die obere Parkposition vorgesehen. Hierzu dienen als bevorzugte Ausführungsform die Merkmale des Anspruches 2. Alternativ hierzu ist die Anordnung nach Anspruch 4 vorgesehen.

Die Merkmale des Anspruches 4 sichern die Lage der Blende in der oberen Parkposition und arretieren dabei die Blende gegen ein versehentliches Verlagern. Hiermit sind im oberen Badbereich einfache Widerlager für die Bestimmung der oberen Parkposition der Blende und deren Halt in dieser Lage geschaffen. Sie sind in der Vertikalen schmal und daher in der Vertikalen von geringer Längenausdehnung. Sie müssen lediglich am oberen, von der Badflüssigkeit nicht berührten Behälterrand befestigt werden.

Die Merkmale der Ansprüche 5 und 6 sind Ausführungsmöglichkeiten für den Halt und die Führung der Blende durch die Stempelenden.

Die Merkmale des Anspruches 7 bewirken, daß in der Arbeitslage der elektrolytischen Behandlung die Blende den unteren Bereich des zu behandelnden Gutes hält, es sich also nicht ungewollt aus dieser senkrechten Lage heraus verlagern kann.

Die Merkmale des Anspruches 8 beinhalten, daß die Blende gegen den unteren Bereich des Behandlungsgutes keine Druckkraft ausübt.

Die Merkmale des Anspruches 9 dienen weiter der Führung der Blende durch die Stempel und erleichtern das Einführen des Werkstückes in die Blende. Die Merkmale des Anspruches 10 erlauben eine Anpassung an unterschiedlich langes Behandlungsgut.

Die Ansprüche 11 und 12 befassen sich mit einer vorteilhaften Ausgestaltung der Blende.

Weitere Merkmale der Erfindung sind den weiteren Unteransprüchen zu entnehmen. Weitere Vorteile ergeben sich aus der nachstehenden Beschreibung und der zugehörigen Zeichnung von erfindungsgemäßen Ausführungsbeispielen. In der Zeichnung, die im wesentlichen schematisch ist, zeigt:
- Fig. 1:: eine Anordnung nach der Erfindung in der Seitenansicht mit Blende, Stempel und Behandlungsgut in der Arbeitslage,
- Fig. 2:: die zu Fig. 1 gehörende Stirnansicht gemäß dem Pfeil II in Fig. 1,
- Fig. 3:: in der Stirnansicht gemäß Pfeil II betrachtet lediglich die Blende in der Parkposition mit völlig nach oben abgehobenem Stempel,
- Fig. 4:: eine Stirnansicht analog Fig. 3, wobei aber der Stempel sich nach unten bis in die Parkposition der Blende bewegt hat.
- Fig. 5:: eine weitere Ausführungsform der Erfindung in einer Seitenansicht analog der Seitenansicht der Fig. 1.

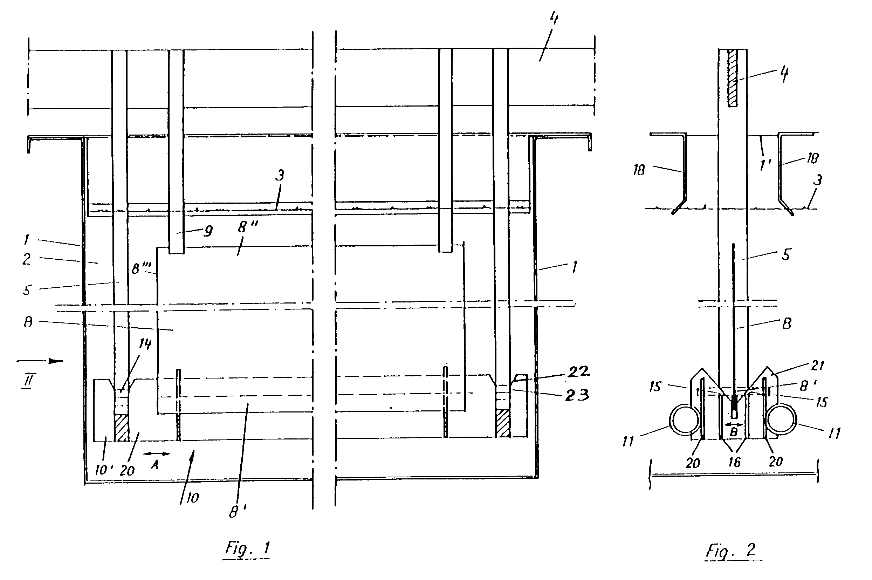

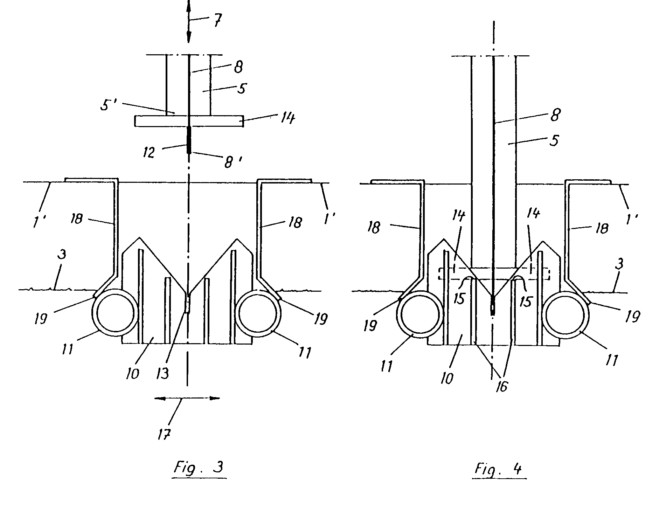

Ein Badbehälter 1 mit Badflüssigkeit 2 ist in Fig. 1 komplett und in den übrigen Figuren teilweise dargestellt. Der Badspiegel ist mit 3 beziffert. Am Warenträger 4 sind zwei Stempel 5 befestigt, die mit dem Absenken bzw. Anheben des Warenträgers 4 (siehe Doppelpfeil 7 in Fig. 3) in das Bad 2 eingetaucht bzw. wieder aus diesem herausgezogen werden. Das zu behandelnde Gut 8 ist, z.B. über angedeutete Klammern 9, am Warenträger 4 lösbar angehängt, hängt von diesem frei nach unten und wird mit dessen Bewegung gemäß dem Doppelpfeil 7 ebenfalls ins Bad 2 eingetaucht bzw. aus diesem herausgezogen. Das allgemein dargestellte und mit 8 bezifferte Behandlungsgut kann aus einem einzigen Werkstück oder aus mehreren Werkstücken bestehen. Mit der Benennung "Behandlungsgut" sind also beide vorgenannten Möglichkeiten erfaßt.

Ferner ist eine Blende 10 vorgesehen, in die der untere Bereich 8' des zu behandelnden Gutes während der Behandlung (siehe Fig. 1 und 2) hineinragt. Hierdurch wird während der Behandlungsphase (Position der Teile gemäß Fig. 1 und 2) verhindert, daß sich zuviel Feldlinien an dem unteren Gutbereich 8' konzentrieren und dort unerwünschte Ansammlungen des durch den elektrolytischen, z.B. galvanischen Prozeß abgeschiedenden Materials bilden.

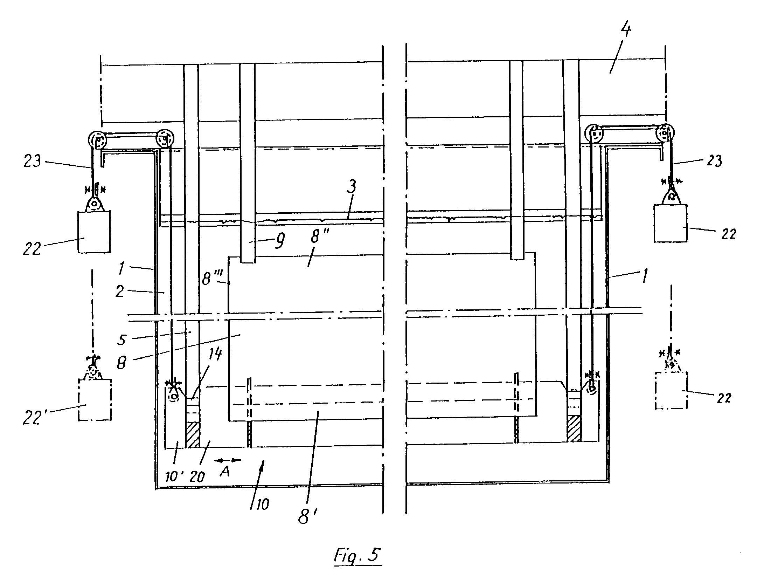

Die Blende 10 ist in vertikaler Richtung auf- und abbewegbar, um zum einen in die vorstehend erläuterte Arbeitslage gemäß Fig. 1 und 2 zu kommen, in der sie einen Teil der Feldlinien gegenüber dem unteren Gutbereich 8' abblendet. Die Fig. 3 und 4 zeigen zum anderen die Blende in der sog. Parkposition, in der sie sich im oberen Bereich des Bades befindet, z.B. in der bevorzugten Ausgestaltung mit angebrachten Schwimmern 11 an der Oberfläche des Bades 2 schwimmt. Fig. 3 zeigt die oberste Position eines der Stempel 5 (der Warenträger 4 ist in Fig. 3 und Fig. 4 nicht dargestellt). An den unteren Enden 5' der Stempel ist zum einen jeweils ein Stutzen 12 angebracht, der in einen Schlitz 13 der Blende paßt. Außerdem sind an den unteren Stempelenden 5' zwei Vorsprünge 14 vorgesehen, die sich quer zur Blendenlängsrichtung erstrecken. Werden die Warenträger mit dem zu behandelnden Gut 8, z.B. eine Leiterplatte, abgesenkt, so hat dies ein entsprechendes Absenken der Stempel 5 zur Folge. Sie gelangen dann mit ihrem Stutzen 12 in den Schlitz 13, wobei die Vorsprünge 14 auf entsprechenden Auflagen, z.B. oberen Stirnflächen 15, von Längsrippen 16 der Blende zur Auflage kommen. Diese Position ist in Fig. 4 dargestellt. Beim weiteren Abwärtsbewegen des Warenträgers 4 bewegt er parallel und synchron zueinander das Gut 8 und die Stempel 5 nach unten, wobei aber auf das Behandlungsgut 8 keine Druckkraft ausgeübt wird. Die Stempel 5 nehmen die Blende 10 aus ihrer Parkposition der Fig. 3 und 4 mit nach unten, bis die Arbeitslage gemäß Fig. 1 und 2 erreicht ist. Das Behandlungsgut ist dabei in seinem unteren Bereich 8' durch einen Schlitz der Blende gehalten, welcher in etwa dem Schlitz 13 gemäß Fig. 3 entspricht und mit diesem fluchtet. Der Schlitz 13 und damit auch der das Behandlungsgut aufnehmende Schlitz in der Blende ragen nach unten so weit vor, so daß beim Aufliegen der Vorsprünge 14 auf den Längsrippen 16 die untere schmale Stirnkante des unteren Behandlungsgutbereiches 8' nicht auf den Boden des Schlitzes 13, bzw. des entsprechenden Schlitzes in der Blende aufstößt. Hiermit ist sichergestellt, daß beim Einbringen des Behandlungsgutes 8 und insbesondere bei dessen Behandlung keine von oben nach unten gerichtete Druckkraft auf das Behandlungsgut ausgeübt wird. Die vorgenannte Verlängerung der Schlitze nach unten sorgt nämlich dafür, daß das plattenförmige Gut 8 nicht auf den Schlitzboden aufstoßen kann.

Der obere Bereich 8'' des Gutes 8 wird von Aufhängemitteln, z.B. Klammern 9 gehalten. Dies hat den Vorteil, daß das plattenförmige Gut 8 die sog. Warenbewegung des. Warenträgers mitmacht, d.h. eine Hin- und Herbewegung des Warenträgers und des Gutes 8 in Richtung des Doppelpfeiles 17 (siehe Fig. 3). Durch die Stempel 5 werden aber auch die Blende 10 und das untere Ende des Behandlungsgutes 8 synchron mitbewegt. Damit die Blende der Bewegung in der Flüssigkeit nicht zu viel Widerstand entgegensetzt, können die Längsrippen 16 und 20 mit Ausnehmungen versehen sein. Zur Erhaltung der Abblendwirkung sind dabei die Ausnehmungen in den Blenden 16 und 20 zueinander versetzt. Ein Verwerfen des Behandlungsgutes 8 ist durch den Halt seines unteren und oberen Bereiches 8', 8'' vermieden, und zwar auch dann, wenn es sich um lange und relativ dünne Platten wie die eingangs erwähnten Leiterplatten handelt. Die Höhe (Länge) des zu behandelnden Gutes kann unterschiedlich sein, wobei bei einem z.B. gegenüber Fig. 1 kürzeren plattenförmigen Gut 8 die untere Gutkante 8' und der Stempel nicht so tief heruntergefahren werden wie es für die Behandlung eines Gutes von der Länge gemäß Fig. 1 notwendig ist. Falls erforderlich oder erwünscht, können die Stempel 5 zum Warenträger 4 höhenverstellbar und in der jeweiligen Höhenlage fixierbar sein (in der Zeichnung nicht dargestellt). Die Blende 10 nimmt in jedem Fall, d.h. bei plattenförmigem Gut unterschiedlicher Länge, in der Arbeitslage die Position ein, in der sie den unteren Gutbereich 8' gegen ein Zuviel an Feldlinien abschirmt. Die Längsseiten 8''' des zu behandelnden Gutes sind von Halterungen frei, jedoch können die Stempel 5 so ausgebildet, z. B. mit Abschirmungen versehen sein, daß sie die Seitenkanten des Behandlungsgutes 8 gegen zu hohe Feldlinienkonzentration abschirmen, soweit dies nicht durch andere Mittel geschieht. Derartige Abschirmungen sind besonders bei wechselnder Breite des Behandlungsgutes 8 vorteilhaft.

Die Blende 10 kann aus der Arbeitslage gemäß den Fig. 1 und 2 z.B. durch lösbare Mitnehmer (zeichnerisch nicht dargestellt) der Stempel 5 wieder nach oben in die Parklage der Fig. 3 und 4 gebracht und dort durch ebenfalls nicht dargestellte lösbare Mittel an Widerlagern 18 gehalten werden, die am Rand 1' des Badbehälters 1 befestigt sind. In einer bevorzugten und konstruktiv sowie in der Funktion besonders einfachen Ausführung ist die Blende als Schwimmer ausgebildet oder mit den bereits erwähnten Schwimmern versehen. Dies sind im Ausführungsbeispiel abgeschlossene, etwa rohrförmige Schwimmkörper 11, die sich an den Längsseiten der Blende befinden und mit dieser fest verbunden sind. Die Schwimmkörper 11 sind so bemessen, daß sie der Blende 10 einen Auftrieb geben, der sie von selbst aus der Arbeitslage in die Parkposition bringt. In der Parkposition der Fig. 3 kommen die Schwimmer 11 zur Anlage an Abwinkelungen 19 der Widerlager 18 und werden somit durch ihren Auftrieb von selbst in der gewünschten Parkposition gehalten. Durch Abheben der Stempel mit Stutzen 12 und Vorsprüngen 14 werden die Stempel durch den Warenträger aus der Lage gemäß Fig. 4 in die Position gemäß Fig. 3 gebracht. Zugleich ist das behandelte Gut 8 ebenfalls mit ausgehoben und kann durch den Warenträger weiterbewegt werden. Fig. 5 zeigt hierzu eine weitere Ausführungsmöglichkeit der Erfindung. Hierbei wird, nach Abheben der Stempel 5, die Blende 10 mittels Gewichte 22 über Zugseile 23 aus der Arbeits- oder Behandlungslage (obere Position der Gewichte 22) in die obere Parkposition gebracht, wobei die Zeichnung zur oberen Parkposition nur die entsprechende untere Lage 22' der Gewichte 22 zeigt, aber aus Gründen der zeichnerischen Vereinfachung nicht auch die obere Parkposition der Blende.

Die Warenträger mit Gut und Stempel werden mittels einer nicht dargestellten Transporteinrichtung durch die gesamte Behandlungsanlage - von Station zu Station - bewegt.

Die beiden Endbereiche 10' der Blende 10 sind zur Aufnahme, zumindest für die Möglichkeit der Auflage der unteren Stempelenden 5' geeignet und ausgebildet. Die bereits teilweise erläuterte Ausbildung der Blendenenden 10' dieses Ausführungsbeispieles ist darüber hinaus in Verbindung mit einer entsprechenden Ausgestaltung der unteren Bereiche der Stempel 5 so gewählt, daß bei Auflage der Stempel auf der Blende diese sich gegenseitig sowohl in Längsrichtung A als auch in Querrichtung B (siehe Fig. 1 und 2) der Blende unverrückbar aneinander halten. Dies geschieht zum einen durch den Eingriff des Stutzens 12 in den Schlitz 13 (zum Halt in Querrichtung B) und ferner durch eine Formgebung der Blende in Art von Einweisungen 22 mit sich daran anschließender Öffnung 23 zur Einführung der Stempelenden und Halt deren Vorsprünge 14 in Längsrichtung A.

Die Blende kann aus einer Reihe von Längsrippen 20 bestehen, die zumindest in den Endbereichen 10' durch Querplatten 21 miteinander verbunden sind. Die Längsrippen 20 und die Querplatten 21 bestehen aus elektrisch nicht leitenden Materialien, z.B. einem Kunststoff. Sie besitzen die Ausschnitte oder Schlitze zur Aufnahme des unteren Gutbereiches 8' und auch zur Auflage und zum Halt der Stempelenden 5' zwecks Verhinderung einer Relativverlagerung der Blende zu den Stempeln in den Richtungen A und B.

## Patentansprüche

1. Vorrichtung zum Abblenden von Feldlinien in einer Anlage zur elektrolytischen Behandlung von im wesentlichen plattenförmigen, aus einem Werkstück oder aus mehreren Werkstücken bestehendem Behandlungsgut, das unterhalb eines Warenträgers gehalten ist und bei dessen Absenken in ein Bad eingebracht wird, wobei eine in Vertikalrichtung durch Niederhalter verstellbare Blende vorgesehen ist, die im Betrieb am unteren Bereich des Behandlungsgutes die o.g. Feldlinienabblendung bewirkt, wobei die Niederhalter mit der Bewegung des Warenträgers gekoppelt sind, dadurch gekennzeichnet, daß die Niederhalter vom Warenträger nach unten ragende Stempel (5) sind, die zur Auflage an beiden Endbereichen (10') der Blende (10) ausgebildet sind, wobei die unteren Enden (5') der Stempel (5) und die Endbereiche (10') der Blende (10), auf welche diese Stempelenden zur Auflage kommen, so ausgebildet sind, daß sich die Blende zumindest in ihrer Längsrichtung nicht relativ zu den Stempeln verschieben kann, daß der Abstand zwischen den Stempeln (5) größer ist als die gesamte Breite des bei der Behandlung zwischen den Stempeln befindlichen Behandlungsgutes (8), daß Mittel zum Transport der Blende aus der unteren Arbeitslage (Fig. 1 und 2) in eine obere Parkposition (Fig. 3 und 4) vorgesehen sind, daß das Behandlungsgut von dem Warenträger (4) ohne seitliche Halterungen nach unten hängt, und daß zwischen Badbehälter (1) und Blende (10) keine Führungen bestehen.

2. Vorrichtung nach Anspruch 1, dadurch gekennzeichnet, daß die Blende (10) als Schwimmer ausgebildet oder mit Schwimmkörpern (11) versehen ist derart, daß ihr Auftrieb sie innerhalb der Badflüssigkeit (2) aus der Arbeitslage in die Parkposition bringt.

3. Vorrichtung nach Anspruch 1, dadurch gekennzeichnet, daß die Blende (10) über Bänder oder Seile (23) mit außerhalb des Badbehälters (1) angeordneten Gewichten (22) oder Federn verbunden ist, welche nach erfolgter Behandlung des Gutes (8) und Hochziehen der Stempel (5) die Blende (10) aus ihrer Arbeitslage in ihre Parkposition anheben.

4. Vorrichtung nach einem der Ansprüche 1 bis 3, dadurch gekennzeichnet, daß im oberen Badbereich Widerlager (18) vorgesehen sind und Anlageflächen oder Haltemittel (19) für die Blende in deren oberer Parkposition aufweisen.

5. Vorrichtung nach einem der Ansprüche 1 bis 4, dadurch gekennzeichnet, daß die Endbereiche (10') der Blende, die zur Auflage der unteren Stempelenden (5') vorgesehen sind, zumindest in Blendenlängsrichtung (A) betrachtet vor und hinter den auf der Blende aufliegenden Stempelenden (5') daran anliegende Arretierungen oder Widerlager (20) aufweisen.

6. Vorrichtung nach einem der Ansprüche 1 bis 5, dadurch gekennzeichnet, daß die Stempelenden (5') unterseitig einen Stutzen (12) und die Blende einen die Stutzen aufnehmenden Schlitz (13) aufweisen.

7. Vorrichtung nach einem der Ansprüche 1 bis 6, dadurch gekennzeichnet, daß das Gut (8) in seinem unteren Bereich (8') durch einen Schlitz der Blende (10) gehalten ist.

8. Vorrichtung nach Anspruch 6 oder 7, dadurch gekennzeichnet, daß bei Halt des Behandlungsgutes (8) in der Arbeitslage der Boden der Schlitze der Blende (10) tiefer liegt als die untere Stirnkante des Behandlungsgutes.

9. Vorrichtung nach einem der Ansprüche 1 bis 8, dadurch gekennzeichnet, daR die Blende sog. Einweisungen zum Einführen des unteren Stempelendes bzw. daran befestigten Stutzen (12) und Vorsprüngen (14) aufweist, wobei eine Einweisung sowohl in Blendenlängsrichtung (A) als auch in Blendenquerrichtung (B) gegeben ist, und daß die Einweisungen auch zum Einführen des Behandlungsgutes in den Schlitz der Blende dienen.

10. Vorrichtung nach einem der Ansprüche 1 bis 9, dadurch gekennzeichnet, daß die Stempel (5) am Warenträger (4) höhenverstellbar und in der jeweiligen Höhenlage fixierbar sind.

11. Vorrichtung nach einem der Ansprüche 1 bis 10, dadurch gekennzeichnet, daß die Blende aus Längsrippen (20) und Querplatten (21) besteht, wobei sich die Querplatten (21) zumindest in den Endbereichen (10') der Blende (10) befinden.

12. Vorrichtung nach Anspruch 11, dadurch gekennzeichnet, daR die Längsrippen (20) und die Querplatten (21) aus einem elektrisch nicht leitenden Material, z. B. einem Kunststoff bestehen.

13. Vorrichtung nach einem der Ansprüche 2 bis 12, dadurch gekennzeichnet, daß Schwimmkörper (11) an den Längsseiten der Blende (10) angebracht sind und von dort her nach außen vorragen.

14. Vorrichtung nach einem der Ansprüche 1 bis 13, dadurch gekennzeichnet, daß die Stempel so ausgebildet sind, daß sie die Seitenkanten des Behandlungsgutes (8) gegen zu hohe Feldlinienkonzentration abschirmen, oder daß sie Abschirmungen tragen.

15. Vorrichtung nach einem der Ansprüche 1 bis 14, dadurch gekennzeichnet, daß zur Erleichterung der synchronen Mitbewegung der Blende (10) durch die Stempel (5) die Blende, insbesondere deren Längsrippen (16, 20) mit Ausnehmungen versehen sind, wobei die Ausnehmungen der Längsrippen (16) zu denen der Längsrippen (20) versetzt sind.

16. Vorrichtung nach einem der Ansprüche 4 bis 15, dadurch gekennzeichnet, daß die Widerlager (18) und Anlageflächen oder Haltemittel (19) im oberen Badbereich die Funktion einer Abblendung von Feldlinien am oberen Bereich (8'') des Behandlungsgutes (8) besitzen.

## Claims

1. Apparatus for the protective screening from lines of electrical flux in a system for the electrolytic treatment of a substantially plate-shaped article to be treated, which comprises a workpiece or a plurality of workpieces, said article being retained beneath an article carrier and introduced into a bath when said carrier is lowered, a screen being provided, which is displaceable in the vertical direction by lowering means and effects the above-mentioned protective screening from lines of electrical flux at the lower region of the article to be treated during the operation, the lowering means being coupled with the movement of the article carrier, characterised in that the lowering means are rams (5), which protrude downwardly from the article carrier and are provided as means for supporting both end regions (10') of the screen (10), the lower ends (5') of the rams (5) and the end regions (10') of the screen (10), on which these ram ends are supported, being so configured that the screen cannot be displaced relative to the rams at least with respect to its longitudinal direction, in that the spacing between the rams (5) is greater than the entire width of the article to be treated (8), which is situated between the rams during the treatment, in that means are provided for conveying the screen from the lower operative position (Figs. 1 and 2) into an upper parked position (Figs. 3 and 4), in that the article to be treated hangs downwardly from the article carrier (4) without lateral holders, and in that no guide means are present between the bath container (1) and screen (10).

2. Apparatus according to claim 1, characterised in that the screen (10) is configured as a float or is provided with floating bodies (11) in such a manner that its buoyancy brings it from the operative position into the parked position within the bath solution (2).

3. Apparatus according to claim 1, characterised in that the screen (10) is connected to weights (22) or springs via belts or cables (23), said weights being disposed externally of the bath container (1) and lifting the screen (10) from its operative position into its parked position after the article (8) has been treated and the rams (5) have been raised.

4. Apparatus according to one of claims 1 to 3, characterised in that supports (18) are provided in the upper bath region and have abutment faces or retaining means (19) for the screen in its upper parked position.

5. Apparatus according to one of claims 1 to 4, characterised in that the end regions (10') of the screen, which are provided in order to support the lower ram ends (5'), have locking means or supports (20), which abut against the ram ends (5'), upstream and downstream of said ram ends, which lie on the screen, when viewed at least with respect to the longitudinal direction (A) of the screen.

6. Apparatus according to one of claims 1 to 5, characterised in that the lower regions of the ram ends (5') have a pipe connection (12), and the screen has a slot (13) which receives the pipe connections.

7. Apparatus according to one of claims 1 to 6, characterised in that the article (8) is retained in its lower region (8') by a slot in the screen (10).

8. Apparatus according to claim 6 or 7, characterised in that, when the article to be treated (8) is retained in the operative position, the base of the slots in the screen (10) is situated lower than the lower front edge of the article to be treated.

9. Apparatus according to one of claims 1 to 8, characterised in that the screen has so-called guide members for the introduction of the lower ram end, or respectively pipe connections (12) and projection members (14) which are mounted thereon, one guide member extending both in the longitudinal direction (A) of the screen and in the transverse direction (B) of the screen, and in that the guide members also serve to introduce the article to be treated into the slot in the screen.

10. Apparatus according to one of claims 1 to 9, characterised in that the rams (5) are vertically displaceable on the article carrier (4) and securable in the respective vertical position.

11. Apparatus according to one of claims 1 to 10, characterised in that the screen comprises longitudinal ribs (20) and transverse plates (21), the transverse plates (21) being situated in at least the end regions (10') of the screen (10).

12. Apparatus according to claim 11, characterised in that the longitudinal ribs (20) and the transverse plates (21) are formed from an electrically non-conductive material, e.g. a plastics material.

13. Apparatus according to one of claims 2 to 12, characterised in that floating bodies (11) are mounted on the longitudinal sides of the screen (10) and protrude outwardly therefrom.

14. Apparatus according to one of claims 1 to 13, characterised in that the rams are so configured that they screen the lateral edges of the article to be treated (8) from too high a concentration of lines of electrical flux, or in that they support protective screens.

15. Apparatus according to one of claims 1 to 14, characterised in that, in order to facilitate the synchronous movement of the screen (10) by means of the rams (5), the screen, more especially its longitudinal ribs (16, 20), are provided with recesses, the recesses in the longitudinal ribs (16) being offset from those in the longitudinal ribs (20).

16. Apparatus according to one of claims 4 to 15, characterised in that the supports (18) and abutment faces or retaining means (19) have, in the upper bath region, the function of a protective screen from lines of electrical flux at the upper region (8'') of the article to be treated (8).

## Revendications

1. Dispositif d'arrêt de lignes de champ sur une installation de traitement électrolytique d'objets à traiter sensiblement en forme de plaques et constitués d'une pièce ou de plusieurs pièces, lesdits objets étant maintenus sous un support d'objets et étant plongés dans un bain lors de la descente dudit support, un écran pouvant être réglé en position verticale par des éléments de maintien en position basse étant prévu, qui en service, assure l'arrêt des lignes de champ susmentionné, dans la zone inférieure des objets à traiter, les éléments de maintien en position basse étant couplés au déplacement des supports,
caractérisé en ce que les éléments de maintien en position basse sont des poinçons (5) faisant saillie vers le bas, qui sont conformés pour prendre appui sur les deux secteurs d'extrémité (10') de l'écran (10), les extrémités inférieures (5') des poinçons (5) et les secteurs d'extrémité (10') de l'écran (10), sur laquelle viennent en appui lesdites extrémités de poinçon, étant conformés de manière telle, que l'écran ne peut pas se déplacer en translation par rapport aux poinçons, du moins dans son sens longitudinal, que l'écartement entre les poinçons (5) est supérieur à la largeur totale des objets à traiter (8) situés entre les poinçons lors du traitement, en ce que des moyens sont prévus pour transporter l'écran depuis la position basse de travail (figures 1 et 2) dans une position haute de repos (figures 3 et 4), en ce que les objets à traiter sont suspendus au support d'objets (4), vers le bas, sans aucune fixation latérale et en ce qu'il n'existe aucun élément de guidage entre la cuve(1) et l'écran (10).

2. Dispositif selon la revendication 1, caractérisé en ce que l'écran (10) est conformé comme un flotteur ou est pourvu de flotteurs (11) de sorte que son élévation à l'intérieur du bain (2) l'amène de la position de travail dans la position de repos.

3. Dispositif selon la revendication 1, caractérisé en ce que l'écran (10) est relié par l'intermédiaire de bandes ou câbles (23) à des poids (22) ou des ressorts, disposés à l'extérieur de la cuve (1), qui, une fois le traitement des objets (8) achevé et les poinçons (5) relevés, amènent l'écran (10) de la position de travail à la position de repos en la soulevant.

4. Dispositif selon l'une quelconque des revendications 1 à 3, caractérisé en ce que des butées (18) sont prévues dans le secteur supérieur du bain et présentent des surfaces d'appui ou dispositifs de maintien (19) de l'écran dans sa position haute.

5. Dispositif selon l'une quelconque des revendications 1 à 4, caractérisé en ce que les secteurs d'extrémité (10') de l'écran, qui sont prévus pour l'appui des extrémités inférieures des poinçons (5), présentent des crans d'arrêts ou butées (20), devant et derrière les extrémités (5') des poinçons reposant sur l'écran, du moins lorsqu'on les observe dans le sens longitudinal de l'écran (A).

6. Dispositif selon l'une quelconque des revendications 1 à 5, caractérisé en ce que les extrémités (5') des poinçons présentent en partie basse, une goulotte (12) et en ce que l'écran présente une fente (13) recevant la goulotte.

7. Dispositif selon l'une quelconque des revendications 1 à 6, caractérisé en ce que l'objet (8) est maintenu dans son secteur inférieur (8') par une fente de l'écran (10).

8. Dispositif selon l'une quelconque des revendications 6 ou 7, caractérisé en ce que lorsque l'objet à traiter (8) est maintenu en position de travail, le fond de la fente de l'écran (10) étant placé plus bas que l'arête frontale inférieure de l'objet à traiter.

9. Dispositif selon l'une quelconque des revendications 1 à 8, caractérisé en ce que l'écran présente des évidements permettant d'introduire l'extrémité inférieure du poinçon ou de la goulotte (12) qui y est fixée et des saillies, un évidement existant aussi bien dans le sens longitudinal (A) de l'écran que dans le sens transversal (B) de l'écran, et en ce que les évidements servent également à introduire l'objet à traiter dans la fente de l'écran.

10. Dispositif selon l'une quelconque des revendications 1 à 9, caractérisé en ce que les poinçons (5) sont réglables en hauteur sur le support d'objets (4) et peuvent être fixés dans la position de réglage en hauteur considérée.

11. Dispositif selon l'une quelconque des revendications 1 à 10, caractérisé en ce que l'écran est constitué de nervures longitudinales (20) et de plaques transversales (21), les plaques transversales (21) se situant au moins dans les secteurs d'extrémité (10') de l'écran (10).

12. Dispositif selon la revendication 11, caractérisé en ce que les nervures longitudinales (20) et les plaques transversales (22) sont constituées d'un matériau non conducteur, par exemple du plastique.

13. Dispositif selon l'une quelconque des revendications 2 à 12, caractérisé en ce que les flotteurs (11) sont montés sur les côtés longitudinaux de l'écran (10), à partir desquels ils font saillie.

14. Dispositif selon l'une quelconque des revendications 1 à 13, caractérisé en ce que les poinçons sont conformés de manière telle qu'ils protègent les arêtes latérales de l'objet à traiter (8) contre de trop fortes concentrations de lignes de champ, ou qu'ils portent des protections.

15. Dispositif selon l'une quelconque des revendications 1 à 14, caractérisé en ce que, pour faciliter l'entraînement synchrone de l'écran (10) par les poinçons (5) l'écran et en particulier ses nervures longitudinales (16, 20) sont pourvues d'évidements, les évidements des nervures longitudinales (16) étant décalés par rapport à ceux des nervures longitudinales (20).

16. Dispositif selon l'une quelconque des revendications 4 à 15 caractérisé en ce que les butées (18) et les surfaces d'appui ou éléments de maintien (19) ont, dans la partie supérieure du bain, une fonction d'écran contre les lignes de champ dans le secteur supérieur (8'') de l'objet à traiter (8).
